# EUROPÄISCHE PATENTSCHRIFT

(11) **EP 1 324 057 B1**
(45) Veröffentlichungstag und Bekanntmachung des Hinweises auf die Patenterteilung: **08.05.2013**
(21) Anmeldenummer: 02024724.3
(22) Anmeldetag: 06.11.2002
(51) Int. Cl.: G01R 22/06, G01D 4/02, G01R 22/00

(54) **Elektronischer Elektrizitätszähler, insbesondere Haushaltszähler**
Electronic energy meter, in particular domestic meter
Compteur d'électricité électronique, notamment compteur domestique

(30) Priorität: 24.12.2001 DE 20120947 U
(43) Veröffentlichungstag der Anmeldung: 02.07.2003
(73) Patentinhaber: EMH metering GmbH & Co. KG, 19243 Wittenburg (DE)
(72) Erfinder: Malek, Norbert, 21438 Thieshope (DE)
(74) Vertreter: Hauck Patent- und Rechtsanwälte

(56) Entgegenhaltungen:
- EP-A- 0 649 024
- EP-A- 0 913 696
- WO-A-99/08119
- DE-A1- 19 653 475
- GB-A- 2 276 728
- US-A1- 2001 043 062
- PATENT ABSTRACTS OF JAPAN vol. 2000, no. 09, 13. Oktober 2000 (2000-10-13) & JP 2000 162256 A (MATSUSHITA ELECTRIC WORKS LTD), 16. Juni 2000 (2000-06-16)

## Beschreibung

Die Erfindung bezieht sich auf einen elektronischen Elektrizitätszähler, insbesondere Haushaltszähler nach dem Anspruch 1.

Die so genannte Eichgültigkeitsdauer von elektronischen Elektrizitätszählern ist zeitlich begrenzt. Zur Überprüfung des Zählers ist dieser auszubauen bzw. auszuwechseln. Hierfür muss der Versorgungsanschluss des Stromabnehmers spannungslos geschaltet werden.

Das Eichgesetz erlaubt nicht, die Funktionen eines Elektrizitätszählers durch ein Software Update zu modifizieren oder Softwarefehler zu korrigieren. Auch hierfür ist ein Ein- und Ausbau des Elektrizitätszählers erforderlich.

Herkömmliche elektronische Elektrizitätszähler haben einen Stromwandler bzw. - sensor, sowie ein elektronisches Messmodul. Diese beiden Elemente bilden eine Einheit, durch die der Energieverbrauch gemessen und angezeigt wird.

Die Druckschrift EP 0 913 696 A2 zeigt einen modular aufgebauten elektronischen Elektrizitätszähler mit einem Modul M, das sowohl ein Zählermodul als auch Stromwandler enthält. Das Modul wird in ein erstes Gehäuse eingesetzt. Ein weiteres Gehäuse enthält eine Karte für zusätzliche Funktionen.

Aus der Druckschrift DE 196 53 475 A1 ist eine Anschlussvorrichtung für einen Drehstromzähler bekannt geworden. Stromklemmen zur Verbindung mit den vier Leitern eines Stromnetzes und zwei externen Stromwandlern sind an einem Adapterklemmblock ausgebildet. Der Adapterklemmblock weist weiterhin zählerseitige Anschlussklemmen auf, die mit Hilfe von Anschlussstiften mit den Anschlussklemmen eines Drehstromzählers verbunden werden. Innerhalb des Adapterklemmblocks sind die netz- und zählerseitigen Anschlüsse so verbunden, dass die beiden externen Stromwandler gemäß einer Aronschaltung mit den drei Leistungsmessern des Drehstromzählers verbunden werden.

Der Erfindung liegt die Aufgabe zugrunde, einen elektronischen Elektrizitätszähler, insbesondere Haushaltszähler, zu schaffen, der die oben genannten Nachteile nicht aufweist.

Diese Aufgabe wird durch einen elektronischen Elektrizitätszahler mit den Merkmalen des Anspruchs 1 gelöst.

Bei dem erfindungsgemäßen Eiektrizitatszähler ist ein separates Zählermodul innerhalb einer plombierbaren Zählerbasiseinheit untergebracht. Das Zählermodul ist über einen Steckverbinder mit der Zählerbasiseinheit zusammensteckbar. Die Zählerbasiseinheit weist ihrerseits ein plombierbares Gehäuse auf, in dem auch das elektronische Zählermodul untergebracht ist. Eine solche Anordnung weist etliche Vorteile auf.

Bei einem Wechsel des Zählermoduls muss die Stromversorgung des Stromabnehmers nicht unterbrochen werden. Das Wechseln des Zählermoduls hat die gleiche Bedeutung wie das Wechseln des Zählers in einem klassischen Messsatz, bei dem Stromwandler und Elektrizitätszähler zwei voneinander unabhängige Geräte sind.

Die Schnittstelle zwischen Stromwandler einerseits und Zählermodul andererseits ist eindeutig definiert und genügt mithin den Genauigkeitsanforderungen des Zählers bei Verwendung unterschiedlicher Zählermodule.

Modulgehäuse und Zählergehäuse sind eichtechnisch absicherbar, wie dies den Bestimmungen zufolge erforderlich ist.

Die Zählerbasiseinheit mit den integrierten Stromwandlem sind zeitlich unbegrenzt beglaubigungsfähig oder verfügen zumindest über eine deutlich längere Eichgültigkeit als elektronische Zähler. Sie können daher auf unbestimmte Dauer in der Installation verbleiben. Somit können die vom Zählermodul abgesetzten Stromwandler wie separate bzw. externe Stromwandler betrachtet werden und eichrechtlich wie Stromwandler behandelt werden.

Das Zählermodul ist ein eigenständiger elektronischer Elektrizitätszähler mit einem eigenen Gehäuse, das ein Austauschen ermöglicht, ohne dass die Zählerbasiseinheit vom Netz getrennt werden muss. Das Zählermodul fällt somit unter das Eichrecht für elektronische Elektrizitätszähler.

Nach einer Ausgestaltung der Erfindung sind die Stromwandler stromkompensiert. Das Übersetzungsverhältnis von Primärstrom zu Sekundärstrom ist eindeutig an das Verhältnis von Primär- zu Sekundärwicklung (Kompensationswicklung) gekoppelt. Änderungen der Kerneigenschaften oder des Übergangswiderstandes der Steckverbindungen werden durch die Schleifenverstärkung der Kompensationsregelung in einem weiten Bereich eliminiert.

Bei der Erfindung sind die Stromwandler leerlauffest. Durch das eingesetzte Kernmaterial und die Spannungsfestigkeit werden die Wicklungen leerlauffest gemacht. Somit ist während des Modulaustausches nicht erforderlich, die Wicklungen des Stromwandlers kurzzuschließen.

Ein Ausführungsbeispiel der Erfindung wird nachfolgend anhand einer Zeichnung näher erläutert.

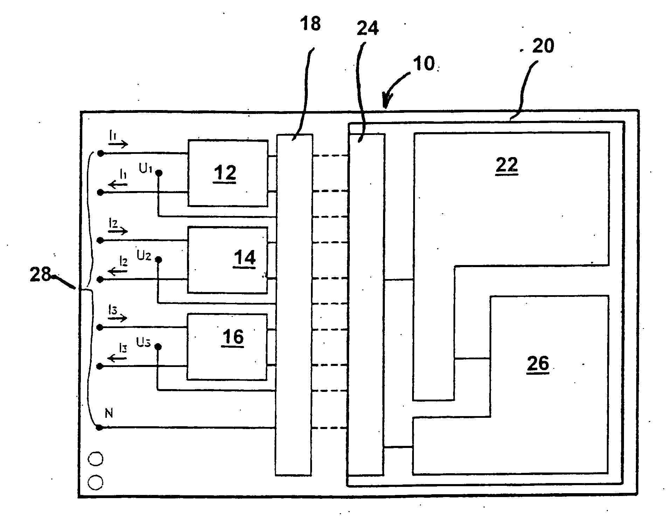

Die einzige Figur zeigt die schematische Darstellung der Funktionsgruppen des erfindungsgemäßen elektronischen Elektrizitätszählers.

Mit dem Kasten 10 soll ein plombierbares Gehäuse für einen elektronischen Elektrizitätszähler angedeutet sein. Innerhalb des Gehäuses 10 befinden sich drei Stromwandler 12, 14 und 16, die auf einer nicht weiter dargestellten Platine angeordnet sein können. Auf der Platine befinden sich außerdem sieben Klemmen für die feste Verbindung mit dem Stromnetz. Im vorliegenden Fall ist mithin ein Drehstromzähler angedeutet. Es versteht sich, dass in gleicher Weise ein normaler Wechselstromzähler ausgebildet sein kann.

Am Ausgang der Stromwandler 12 bis 16 befindet sich ein erstes Steckverbindungsteil 18, dessen Einzelheiten nicht weiter dargestellt sind. Auch das Steckverbindungsteil 18 ist auf der nicht gezeigten Platine fest angeordnet.

Innerhalb des Gehäuses 10 befindet sich ein zweites Gehäuse 20, das lösbar im Gehäuse 10 untergebracht ist. Es ist ebenfalls plombierbar. Im Gehäuse 20 befindet sich ein Zählermodul 22, das mit einem Steckverbindungsteil 24 im Gehäuse 20 verbunden ist. Die Steckverbindungsteile 18 und 24 können durch ein einfaches Zusammenstecken eine elektrische Verbindung zwischen den Stromwandlern 12 bis 16 und dem Zählermodul herstellen.

Im Gehäuse 20 befinden sich außerdem Zusatzmodule 26 für die Versorgung und den Betrieb des Zählermoduls, worauf im Einzelnen nicht eingegangen werden muss. Dies gehört zum Stand der Technik.

Nach dem Öffnen des Gehäuses 10 kann das Gehäuse 20 ohne weiteres entfernt werden, z.B. zum Austausch mit einem anderen ein Zählermodul enthaltendes Gehäuse. Hierbei können die Klemmen, die zusammen mit 28 bezeichnet sind, fest mit dem Netz verbunden bleiben. Die Stromwandler 12 bis 16 sind im Übrigen so ausgelegt, dass sie im Leerlauf nicht kurzgeschlossen werden müssen.

## Patentansprüche

1. Elektronischer Elektrizitätszähler, insbesondere Haushaltszähler, mit
• Stromklemmen (28),
• Stromwandlern (12 bis 16), die mit einem ersten Steckverbindungsteil (18) verbundenen sind,
• einem elektronischen Zählermodul (22), das mit einem zweiten Steckverbindungsteil (24) verbunden ist, das mit dem ersten Steckverbindungsteil (18) zusammensteckbar ist für die elektrische Verbindung der Stromwandler (12 bis 16) mit dem Zählermodul (22), **dadurch gekennzeichnet, dass**
• die Stromwandler (12 bis 16) leerlauffest und gemeinsam mit den Stromklemmen (28) und dem ersten Steckverbindungsteil (18) in einem plombierbaren ersten Gehäuse (10) einer Zählerbasiseinheit angeordnet sind, und
• das elektronische Zählermodul (22) in einem separaten plombierbaren zweiten Gehäuse (20) angeordnet ist, das im ersten Gehäuse (10) lösbar anbringbar ist.

2. Elektrizitätszähler nach Anspruch 1, **dadurch gekennzeichnet, dass** die Stromwandler (12 bis 16) stromkompensiert sind.

## Claims

1. An electronic energy meter, in particular a domestic meter, comprising
• current terminals (28),
• current transformers (12 to 16), which are connected to a first plug-and-socket connector assembly (18),
• an electronic counter module (22), which is connected to a second plug-and-socket connector assembly (24) that can be plugged together with the first plug-and-socket connector assembly (18) for the electric connection of the current transformers (12 to 16) to the counter module (22), **characterised in that**
• the current transformers (12 to 16) are disposed, in a short-circuit proof manner and together with the current terminals (28) and the first plug-and-socket connector assembly (18), in a sealable first case (10) of a meter base unit, and
• the electronic counter module (22) is disposed in a separate sealable second case (20), which can be detachably attached in the first case (10).

2. The energy counter according to claim 1, **characterised in that** the current transformers (12 to 16) are current compensated.

## Revendications

1. Compteur d'électricité électronique, notamment compteur domestique, avec
• des bornes de courant (28),
• des transformateurs de courant (12 to 16), qui sont raccordés à un premier ensemble de connecteurs à fiches (18),
• un module de compteur électronique (22), qui est raccordé à un deuxième ensemble de connecteurs à fiches (24) qui est enfichable avec le premier ensemble de connecteurs à fiches (18) pour la connexion électrique des transformateurs de courant (12 to 16) au module de compteur (22), **caractérisé en ce que**
• les transformateurs de courant (12 to 16) sont disposés, de façon protégée contre circuit ouvert et ensemble avec les bornes de courant (28) et le premier ensemble de connecteurs à fiches (18), dans un premier boîtier plombable (10) d'une unité de base de compteur, et
• le module de compteur électronique (22) est disposé dans un deuxième boîtier plombable séparé (20), qui peut être monté de façon amovible dans le premier boîtier (10).

2. Compteur d'électricité selon la revendication, **caractérisé en ce que** les transformateurs de courant (12 to 16) sont à courant compensé.
